# EUROPEAN PATENT APPLICATION

(11) **EP 1 351 124 A2**
(43) Date of publication of application: **08.10.2003**
(21) Application number: 03251981.1
(22) Date of filing: 28.03.2003
(51) Int. Cl.: G06F 3/033

(54) **Display portion integrated type touch panel apparatus and method for manufacturing the same**

(30) Priority: 03.04.2002 JP 2002101589
(71) Applicant: Pioneer Corporation, Meguro-ku, Tokyo (JP)
(72) Inventor: Kawasaki, Kenichi, Meguro-ku, Tokyo (JP); Takagi, Kazunori, Meguro-ku, Tokyo (JP); Oosugi, Jun, Meguro-ku, Tokyo (JP); Nakada, Hitoshi, c/o Corporate Res. Dev. Lab., Tsurugashima-shi, Saitama (JP); Tsuchida, Masami, c/o Corporate Res. Dev. Lab., Tsurugashima-shi, Saitama (JP)
(74) Representative: Haley, Stephen

(57) **Abstract**

A display portion integrated type touch panel apparatus has a substrate, an organic EL display portion formed on one surface of the substrate to emit light externally, and a touch panel portion formed on the other surface of the substrate.

## Description

The present disclosure relates to the subject matter contained in Japanese Patent Application No. 2002-101589 filed April 3, 2002, which is incorporated herein by reference in its entirety.

### 1. Field of the Invention

This invention relates to a display portion integrated type touch panel apparatus which is employed in e.g. an information input terminal apparatus, and a method for manufacturing the same.

### 2. Description of the Related Art

In a touch panel device , an input is made in such a manner that an operator depresses a displayed portion with a finger or a pen. Such a touch panel device has a structure in which a touch panel is superposed on a display device such as a cathode ray tube (CRT) or liquid crystal display panel (LCD). In a portable information terminal equipped with the touch panel device, the liquid crystal display device which is thinner than the CRT has been widely employed as a display device for the touch panel. In addition, weight reduction or thickness reduction of the portable information terminal has been pursued.

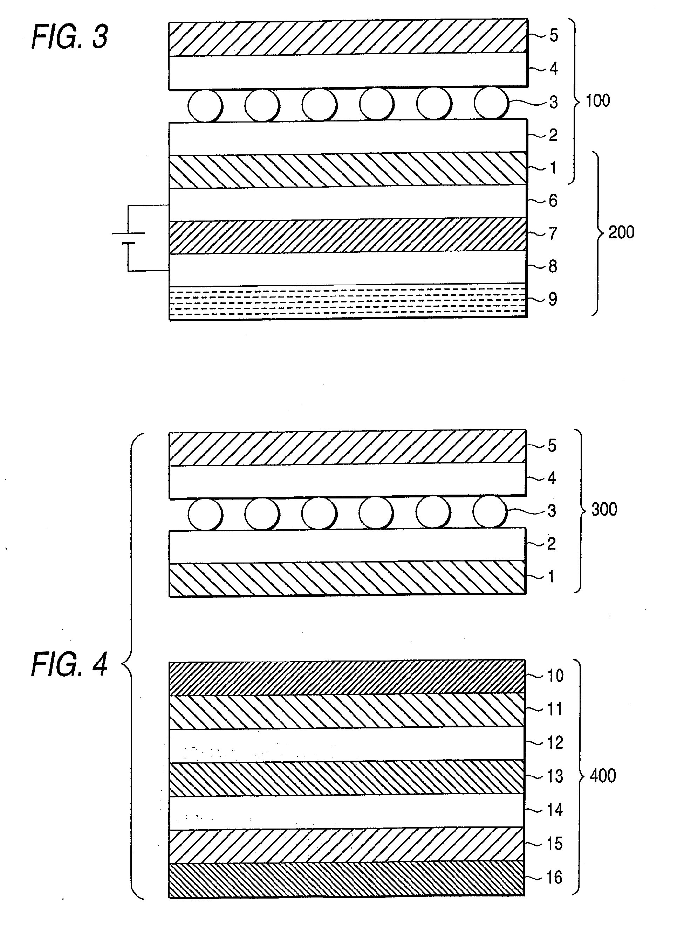

Fig. 4 shows a display portion integrated type touch panel apparatus in which a touch panel is superposed on a liquid crystal display device. As shown in Fig. 4, a touch panel device 300 includes substrates 1 and 5, which are formed of a synthetic resin film or glass sheet, and a pair of electrodes (transparent conductive films 2 and 4), which are formed of a transparent conductive film (e.g. ITO), interposed between the substrates 1 and 5 and opposite to each other via a spacer 3.

An LCD 400 includes a pair of electrodes (transparent conductive films 12 and 14), which are formed of a transparent conductive film (e.g. ITO), interposed between glass substrates 11 and 15 and opposite to each other via a liquid crystal 13. A polarizing plate 10 is arranged outside the substrate 11 and a substrate 16 is arranged outside the substrate 15. A conventional display portion integrated type touch panel apparatus has a structure in which the touch panel device 300 and LCD 400 are superposed on each other in a state where the substrate 1 of the touch panel device 300 and the polarizing plate 10 of LCD 400 are in contact with each other.

The display portion integrated type touch panel apparatus equipped with the LCD, which is thinner than that equipped with the CRT, has been widely adopted in a portable information terminal. However, in order to satisfy the demand of further thickness reduction and weight reduction of the information terminal, the thickness reduction and weight reduction of the touch panel device is also required.

A general technique for realizing the thickness reduction and weight reduction is to implement the thickness reduction, weight reduction and omission of the respective elements which constitute the device. However, this technique has a limit in view of strength of the touch panel device. In addition, in order to realize the display function and the touch panel function, the constituent elements as shown in Fig. 4 are required. Therefore, the conventional touch panel device equipped with the LCD has a structural limit in implementing the thickness reduction.

This invention has been accomplished in view of the circumstance described above, and intends to provide a display portion integrated type touch panel apparatus which can realize thickness reduction and weight reduction without undergoing a structural limit by using an LCD, and a method for manufacturing the same.

According to a first aspect of the invention, there is provided a display portion integrated type touch panel apparatus including: a substrate of glass or resin; a display portion formed on one surface of the substrate to emit light externally; and a touch panel portion formed on the other surface of the substrate.

In accordance with the above configuration in which the display portion on the one side and the touch panel portion on the other side are provided with respect to the substrate which constitutes the display portion integrated type touch panel apparatus, the substrate can be commonized, thereby realizing the thickness reduction and weight reduction of the touch panel device.

According to a second aspect of the invention, the display portion includes a pair of electrodes at least one of which is in contact with the substrate, and a spontaneous light emitting layer interposed between the pair of electrodes.

In accordance with the above configuration in which the display portion constitutes a spontaneous light emitting layer, the touch panel device can omit a polarizing plate required for the conventional touch panel device using a liquid crystal display portion which controls an amount of light by controlling transmission light, thereby achieving weight reduction. Further, in the conventional touch panel device using the liquid crystal display portion, the substrate which constitutes the touch panel portion and the substrate which constitutes the display portion are separated in structure from each other because of the presence of the polarizing plate, whereas in this invention, the two substrates are communized, in view of that they are adjacent to each other without intervention of the polarizing plate, thereby realizing thickness reduction as well as the weight reduction.

According to a third aspect of the invention, the spontaneous light emitting layer is made of an organic compound.

In accordance with the above configuration in which the light emitting layer of organic compound spontaneously emits light, the characteristics of the light emitting layer of organic compound such as a wide angle of view field and high contrast can be used for the touch panel device,.

According to a fourth aspect of the invention, the touch panel portion includes a pair of conductive films which are opposite to each other via a plurality of spacers having predetermined elasticity.

In accordance with the above configuration in which the touch panel portion includes a pair of conductive films, the touch panel portion that can be easily formed on the substrate and having reduced thickness and weight can be provided.

According to a fifth aspect of the invention, there is provided a method for manufacturing a display portion integrated type touch panel apparatus including a substrate of glass or resin, a display portion formed on one surface of the substrate to emit light externally and a touch panel portion formed on the other surface of the substrate, the method including: a first step of forming the touch panel portion on one surface of the substrate; and a second step of forming the display portion on the other surface of the substrate.

In accordance with the above configuration, in which the layers are stacked on both sides of the substrate centrally located in the display portion integrated type touch panel apparatus, the display portion on the one side and the touch panel portion on the other side can be integrally formed with respect to one substrate, thereby improving position accuracy between the touch panel and the display portion. Further, by manufacturing the touch panel portion before the display portion is manufactured, even when higher manufacturing accuracy for an optical characteristic is required for the display portion than for the touch panel portion, the damage for the display portion in the manufacturing process can be minimized, thereby improving the production yield.

According to a sixth aspect of the invention, the first step includes forming a first conductive film on the one surface of the substrate, forming a spacer portion on the first conductive film and forming the second conductive film on the spacer portion; and the second step includes forming a first electrode on the other surface of the substrate, forming a light emitting layer of an organic compound on the first electrode, and forming a second electrode on the light emitting layer.

In the above configuration in which in the first step for forming the touch panel portion, the first conductive film, spacer and second conductive film which constitute the touch panel portion are successively stacked, and in the second step for forming the display portion, the first electrode, light emitting layer and second electrode which constitute the display portion are successively formed, the position accuracy among the elements which constitute the touch panel portion and the display portion can be improved.

According to a seventh aspect of the invention, the method for manufacturing a display portion integrated type touch panel apparatus further includes: fixing the substrate so that the one surface is directed upward before the first step is started; and fixing the substrate so that the other surface is directed upward after the first step is completed and before the second step is started.

In the above configuration in which with respect to the substrate on which the touch panel portion and the display portion are formed, the one side on which the touch panel portion is formed and the other side on which the display portion is formed are fixed to be always directed upward by the first and second step, the touch panel and the display portion which are formed on both sides of the substrate can be stacked from one side, thereby improving the manufacturing efficiency.

**In the drawings:-**
Fig. 1 is a sectional view showing a schematic structure of a display portion integrated type touch panel apparatus according to a first embodiment of this invention;
Fig. 2 is a sectional view showing a schematic structure of a display portion integrated type touch panel apparatus according to a second embodiment of this invention;
Fig. 3 is a sectional view showing a schematic structure of a display portion integrated type touch panel apparatus according to a third embodiment of this invention; and
Fig. 4 is a sectional view showing a schematic structure of a conventional touch panel device using a liquid crystal display device.

Now referring to the drawings, an explanation will be given of embodiments of this invention. Respective layers illustrated in the drawings show only their portions which are necessary to explain the display portion integrated type touch panel apparatus. Those layers actually have different thicknesses than that shown. In all the figures for explaining the embodiments, like reference symbols refer to the elements having like functions.

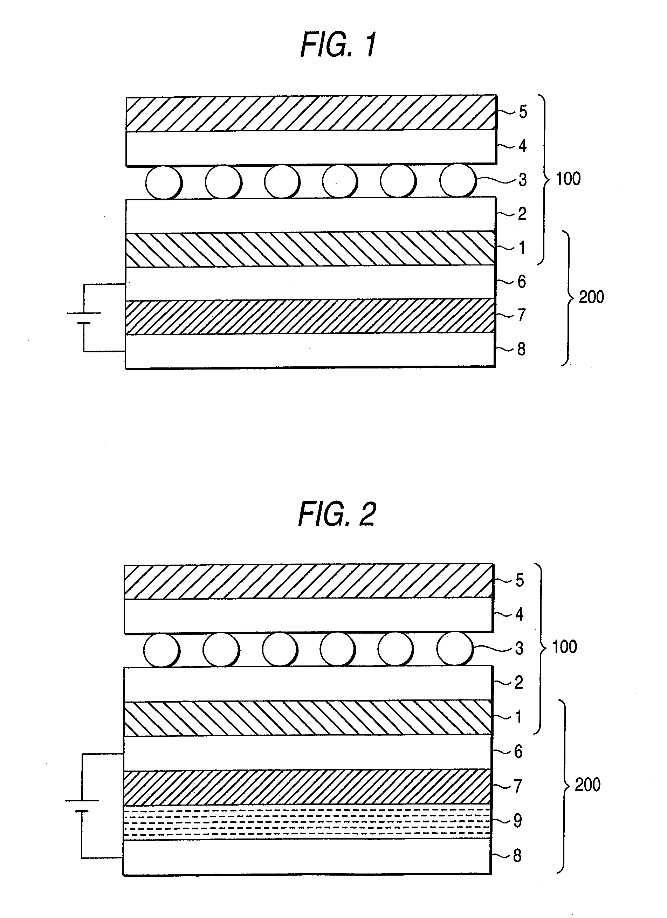

Fig. 1 is a sectional view showing a schematic structure of a display portion integrated type touch panel apparatus according to a first embodiment of this invention. The display portion integrated type touch panel apparatus according to this embodiment includes a touch panel portion 100 and an organic EL display portion 200 equipped with organic EL light-emitting element which is formed integrally to the touch panel portion.

In the touch panel portion 100, a transparent conductive film 2 is formed on a substrate 1, and a substrate 5 with a transparent conductive film 4 formed thereon is arranged oppositely to the substrate 1 via a spacer 3 such as a dot spacer. The substrates 1 and 5 may be formed of a glass sheet or synthetic resin film, the transparent conductive films 2 and 4 may be made of indium oxide (ITO) doped with tin (Sn), indium oxide doped with zinc (Zn), etc. and the spacer may be made of a known material such as an elastic material having predetermined elasticity.

The transparent conductive films 2 and 4 of the touch panel portion 100 may be formed by a known technique, and may be uniformly or in stripe. The operation of the touch panel portion 100 and the theory of detecting positions therefor, which are well known, will be not be explained here.

The organic EL display portion 200 includes a transparent electrode 6 (anode), an organic EL layer 7 and a transparent electrode 8 (cathode) which are stacked on a substrate 1. In the drawing, the respective layers of organic EL display portion 200, which is located below the touch panel portion 100, are stacked downward from the touch panel portion 100. The substrate 1 is commonized for the touch panel portion 100. The transparent electrodes 6 and 8 may be made of indium oxide (ITO) doped with tin (Sn), indium oxide doped with zinc (Zn), etc. The organic EL layer 7 may be made of a known material (organic compound) composed of an organic light-emitting material such as alumiquinolinol complex and fluorescent dye such as coumarin. The organic EL display element provided with the transparent electrode 6 (anode) and transparent electrode 8 (cathode) are well known. Specifically, the transparent electrode 8 (cathode) may be provided with a conductive layer via a buffer layer on the side of the organic EL layer. The organic EL layer may be provided with a hole injection/transportation layer and an electron injection layer on both sides of the organic light emitting material layer. The operation of the organic EL display element and the theory of display thereof, which are well known, will be not be explained here.

The display portion integrated touch panel device according to the first embodiment, which employs an organic EL display portion emitting light spontaneously, can omit a polarizing plate required for the conventional touch panel device using a liquid crystal display portion, thereby achieving weight reduction. Further, conventionally, the substrate which constitutes the touch panel portion and the substrate which constitutes the display portion are separated in structure from each other because of the presence of the polarizing plate, whereas in this embodiment, the two substrates are replaced by commonizing in view of that they are adjacent to each other without intervention of the polarizing plate, thereby realizing thickness reduction as well as the weight reduction. Moreover, since a back light, which is indispensable to a transmission liquid crystal display device, is not necessary, thereby further realizing the weight reduction and thickness reduction. In case where the substrate is made of plastic, the touch panel device can have flexibility in addition to unnecessity of the polarizing plate required in the conventional touch panel device having the liquid crystal display portion and thickness reduction by commonizing of the substrate to further achieve flexibility.

An explanation will be given of a method for manufacturing 'the display portion integrated type touch panel apparatus according to the first embodiment. The display portion integrated type touch panel apparatus according to the first embodiment, in which the substrate is commonized within the device, cannot adopt the method of assembling the touch panel portion and the display portion which have been individually manufactured previously. Therefore, a process of manufacturing the touch panel portion and the display portion in a series of steps is required.

In the method for manufacturing the display portion integrated type touch panel, first, the touch panel portion 100 is manufactured and thereafter the organic EL display portion 200 is manufactured. In the step of manufacturing the touch panel portion 100, first, a transparent conductive film 2 and a spacer 3 are formed on a substrate 1 by a known technique. Next, a substrate 5 with a transparent conductive film 4 formed thereon is stacked so that the transparent conductive films 2 and 4 are opposite to each other. After the touch panel portion 100 is manufactured, it is turned over. On the substrate 1, a transparent electrode 6 (anode), organic EL layer 7 and a transparent electrode 8 (cathode) are stacked successively in this order.

The manufacturing method described above cannot adopt a process of assembling the touch panel portion and the display portion which have been individually manufactured, but can integrally form the display portion on the one side and the touch panel portion on the other side with respect to one substrate by stacking the layers on both sides of the substrate centrally located in the display portion integrated type touch panel apparatus, thereby improving position accuracy between the touch panel portion and the display portion.

In manufacturing the organic EL display portion 200, higher accuracy for patterns of the transparent electrode etc. is required than those of transparent conductive film in the touch panel portion 100. Therefore, if the organic EL display portion 200 is manufactured before the touch panel portion 100 is manufactured, when the touch panel portion is manufactured, vibration or stress is applied to the organic EL display portion manufactured previously, thus generating strong possibility of defective quality such as breakage of the organic EL light-emitting element. However, by manufacturing the touch panel portion 100 beforehand, such possibility can be lowered.

Further, after the touch panel portion stacked on the one surface of the substrate is manufactured, the substrate is turned over and the display portion is formed on the other surface of the substrate. In this way, the touch panel portion and display portion to be formed on both sides of the substrate can be stacked from one side. Therefore, an existing manufacturing line can be employed without making the manufacturing line in a three dimensional form.

Fig. 2 is a sectional view of a schematic structure of a display portion integrated type touch panel apparatus according to a second embodiment of this invention. Like the first embodiment, the display portion integrated type touch panel apparatus according to the second embodiment includes a touch panel portion 100 and an organic EL display portion 200 equipped with an organic EL light-emitting element, which is formed integrally to the touch panel portion. The structure of the touch panel portion 100, which is the same as that in the first embodiment, will not be explained here.

The organic EL display portion 200 has a structure in which a transparent electrode 6 (anode), organic EL layer 7, light absorbing layer 9 and a transparent electrode 8 (cathode) are stacked on the substrate 1. Incidentally, because the organic EL display portion 200 is located below the touch panel portion 100 in the drawing, these layers are stacked downward from the touch panel portion 100. The light absorbing layer 9 is inserted to suppress the reduction in display contrast which is generated when a part of the light emitted from the organic EL layer 7 advances in a direction opposite to the touch panel portion, reflects and advances toward the side of the touch panel portion again. The light absorbing layer 9 is made of a known light absorbing material. The other construction of the organic EL display portion 200, which is the same as that in the first embodiment, will not be explained here.

The display portion integrated type touch panel apparatus according to the second embodiment can be weight-reduced and thickness-reduced as in the first embodiment. The insertion of the light absorbing layer 9 provides a high quality display with good contrast.

An explanation will be given of a method for manufacturing the display portion integrated type touch panel apparatus according to the second embodiment. As in the first embodiment, in the method for manufacturing the display portion integrated type touch panel, first, the touch panel portion 100 is manufactured and thereafter the organic EL display portion 200 is manufactured. In the step of manufacturing the touch panel 100, first, a transparent conductive film 2 and a spacer 3 are formed on a substrate 1 by a known technique. Next, a substrate 5 with a transparent conductive film 4 formed thereon is stacked so that the transparent conductive films are opposite to each other. After the touch panel portion 100 is manufactured, it is turned over. On the substrate 1, a transparent electrode 6 (anode), organic EL layer 7, a light absorbing layer 9 and a transparent electrode 8 (cathode) are stacked successively in this order.

Like the first embodiment, the manufacturing method according to this embodiment can improve the position accuracy between the touch panel portion and the display portion. Further, this manufacturing method can manufacture the touch panel portion without breakage of the touch panel portion.

Fig. 3 is a sectional view of the schematic structure of a display portion integrated type touch panel apparatus according to a third embodiment of this invention. Like the second embodiment, the display portion integrated type touch panel apparatus according to the third embodiment includes a touch panel portion 100 and an organic EL display portion 200 equipped with an organic EL light-emitting element, which is formed integrally to the touch panel portion 100. The structure of the touch panel portion 100, which is the same as that in the second embodiment, will not be explained here.

The organic EL display portion 200 has a structure in which a transparent electrode 6 (anode), organic EL layer 7, a transparent electrode 8 (cathode) and light absorbing layer 9 are stacked on the substrate 1. Incidentally, because the organic EL display portion 200 is located below the touch panel portion 100 in the drawing, these layers are stacked downward from the touch panel portion 100. The light absorbing layer 9 is inserted to suppress the reduction in display contrast which is generated when a part of the light emitted from the organic EL layer 7 advances in a direction opposite to the touch panel portion, reflects and advances toward the side of the touch panel portion again. The light absorbing layer 9 is made of a known light absorbing material. The other construction of the organic EL display portion 200, which is the same as that in the second embodiment, will not be explained here.

The display portion integrated type touch panel apparatus according to the third embodiment can be weight-reduced and thickness-reduced as in the second embodiment. The insertion of the light absorbing layer 9 provides a high quality display with good contrast.

An explanation will be given of a method for manufacturing the display portion integrated type touch panel apparatus according to the third embodiment. As in the second embodiment, in the method for manufacturing the display portion integrated type touch panel, first, the touch panel portion 100 is manufactured and thereafter the organic EL display portion 200 is manufactured. In the step of manufacturing the touch panel portion 100, first, a transparent conductive film 2 and a spacer 3 are formed on a substrate 1 by a known technique. Next, a substrate 5 with a transparent conductive film 4 formed thereon is stacked so that the transparent conductive films are opposite to each other. After the touch panel portion is manufactured, it is turned over. On the substrate 1, a transparent electrode 6 (anode), organic EL layer 7, a transparent electrode 8 (cathode) and a light absorbing layer 9 are stacked successively in this order.

Like the second embodiment, the manufacturing method according to this embodiment can improve the position accuracy between the touch panel portion and the display portion. Further, this manufacturing method can manufacture the touch panel without breakage of the touch panel portion.

In the first, second and third embodiments described above, the organic EL element is employed as the displaymaterial layer. However, as long as the display material layer permits the substrate to be commonized with that of the touch panel portion, any material can be employed. For example, if the display is a liquid crystal display device which does not require the polarizing plate since the liquid crystal serves as the polarizing plate, the liquid crystal may be employed as the display material layer to realize the technical idea of this invention.

As understood from the description hitherto made, in accordance with the display portion integrated type touch panel apparatus according to this invention, in a structure in which the display portion on the one surface and the touch panel portion on the other surface are formed with respect to the substrate which constitutes the display portion integrated type touch panel apparatus, the substrate can be commonized, thereby realizing the thickness reduction and weight reduction of the touch panel device.

In accordance with the method for manufacturing the display portion integrated type touch panel apparatus according to this invention, the display portion on the one surface and the touch panel portion on the other surface can be integrally formed with respect to one substrate by stacking the layers on both sides of the substrate centrally located in the display portion integrated type touch panel apparatus, thereby improving position accuracy between the touch panel portion and the display portion. Further, by manufacturing the touch panel portion before the display portion is manufactured, even when higher manufacturing accuracy for an optical characteristic is required for the display portion than for the touch panel portion, the damage for the display portion in the manufacturing process can be minimized, thereby improving the production yield.

## Claims

1. A display portion integrated type touch panel apparatus comprising:
a substrate of glass or resin;
a display portion formed on one surface of the substrate to emit light externally; and
a touch panel portion formed on the other surface of the substrate.

2. A display portion integrated type touch panel apparatus according to claim 1, wherein the display portion includes a pair of electrodes at least one of which is in contact with the substrate, and a spontaneous light emitting layer interposed between the pair of electrodes.

3. A display portion integrated type touch panel apparatus according to claim 2, wherein the spontaneous light emitting layer is made of an organic compound.

4. A display portion integrated type touch panel apparatus according to claim 1, wherein the touch panel portion includes a pair of conductive films which are opposite to each other via a plurality of spacers having predetermined elasticity.

5. A method for manufacturing a display portion integrated type touch panel apparatus including a substrate of glass or resin, a display portion formed on one surface of the substrate to emit light externally and a touch panel portion formed on the other surface of the substrate, the method comprising:
a first step of forming the touch panel portion on one surface of the substrate; and
a second step of forming the display portion on the other surface of the substrate.

6. A method for manufacturing a display portion integrated type touch panel apparatus according to claim 5, wherein the first step includes forming a first conductive film on the one surface of the substrate, forming a spacer portion on the first conductive film and forming the second conductive film on the spacer portion; and
the second step includes forming a first electrode on the other surface of the substrate, forming a light emitting layer of an organic compound on the first electrode, and forming a second electrode on the light emitting layer.

7. A method for manufacturing a display portion integrated type touch panel apparatus according to claim 5, further comprising:
fixing the substrate so that the one surface is directed upward before the first step is started; and
fixing the substrate so that the other surface is directed upward after the first step is completed and before the second step is started.

8. A method for manufacturing a display portion integrated type touch panel apparatus according to claim 6, further comprising:
fixing the substrate so that the one surface is directed upward before the first step is started; and
fixing the substrate so that the other surface is directed upward after the first step is completed and before the second step is started.
